# EUROPÄISCHE PATENTSCHRIFT

(11) **EP 1 490 742 B1**
(45) Veröffentlichungstag und Bekanntmachung des Hinweises auf die Patenterteilung: **15.11.2006**
(21) Anmeldenummer: 03727139.2
(22) Anmeldetag: 13.03.2003
(51) Int. Cl.: G05F 1/00, H02M 3/07

(54) **SPANNUNGSREGLERANORDNUNG**
VOLTAGE REGULATOR ARRANGEMENT
ENSEMBLE DE REGULATION DE TENSION

(30) Priorität: 03.04.2002 DE 10214941; 28.05.2002 DE 10223727
(43) Veröffentlichungstag der Anmeldung: 29.12.2004
(73) Patentinhaber: Infineon Technologies AG, 81669 München (DE)
(72) Erfinder: FLEISCHMANN, Peter, 80636 München (DE); NEBEL, Gerhard, 87509 Immenstadt (DE); SCHLAFFER, Andreas, 81545 München (DE); WEDER, Uwe, 84072 Au / Hallertau (DE)
(74) Vertreter: Epping - Hermann - Fischer
(86) Internationale Anmeldenummer: PCT/DE2003/000814
(87) Internationale Veröffentlichungsnummer: WO 2003/083595

(56) Entgegenhaltungen:
- US-A- 5 072 134
- US-A- 5 929 694
- US-B1- 6 275 096
- US-B1- 6 351 179

## Beschreibung

Die Erfindung betrifft eine Spannungsregleranordnung mit einem Spannungsregler, der mit einer Schaltungsanordnung verbindbar ist und zur Versorgung derselben vorgesehen ist.

Bei integrierten Schaltungen wird zwischen der internen Versorgungsspannung und der externen Versorgungsspannung unterschieden. Der Eingangsanschluß des Spannungsreglers ist mit der externen Versorgungsspannung beaufschlagt. Der Ausgangsanschluß des Spannungsreglers, der mit der Schaltungsanordnung verbindbar ist, beaufschlagt diese mit der internen Versorgungsspannung. Die Höhe der internen Versorgungsspannung bemißt sich dabei nach den Anforderungen der Schaltungsanordnung. Üblicherweise liegt die interne Versorgungsspannung niedriger als die externe Versorgungsspannung. Der Spannungsregler übernimmt folglich die Aufgabe, die externe Versorgungsspannung auf die interne Versorgungsspannung zu "transformieren". Die interne Versorgungsspannung muß dabei, unabhängig von Spannungsschwankungen der externen Versorgungsspannung möglichst konstant gehalten werden, um die Funktion der zu versorgenden Schaltungsanordnung gewährleisten zu können.

Mit zunehmender Technologieintegration der Bauelemente der zu versorgenden Schaltungsanordnung nimmt die interne Versorgungsspannung ab. Da gleichzeitig der zulässige externe Spannungsbereich aufgrund vorgegebener Normen (z. B. Global System for Mobile Communication GSM oder International Standard Organization ISO) erweitert wird, werden die Anforderungen an den Spannungsregler verschärft, eine gleichbleibende interne Versorgungsspannung bereit zu stellen.

Problematisch ist insbesondere der Ausgleich von Spannungsspitzen, sogenannte Spikes, der externen Versorgungsspannung.

Zum einen können die Spannungsspitzen bei einem vergrößerten externen Spannungsbereich zunehmen. Andererseits muß eine verringerte interne Versorgungsspannung aufgrund der oben angesprochenen Technologieintegration der Bauelemente der Schaltungsanordnung bereitgestellt werden. Dabei wirken sich gleiche Spannungsschwankungen, d.h. deren Absolutwert, bei verringerter interner Versorgungsspannung stärker aus, da die relative Änderung dann größer ist. Herkömmliche Spannungsregler sind deshalb häufig nicht mehr in der Lage, bei großen externen Spannungsschwankungen und geringen geforderten internen Versorgungsspannungen eine ausreichend gleichbleibende interne Versorgungsspannung zu generieren.

Prinzipiell sind aus dem Stand der Technik zwei unterschiedliche Typen von Spannungsreglern bekannt.

Zum einen gibt es integrierte Spannungsregler mit p-Kanal-Längsregeltransistoren, die eine geringe Stromaufnahme, aber eine hohe Spannungsempfindlichkeit aufweisen. Die hohe Spannungsempfindlichkeit ist dadurch verursacht, daß die externe Versorgungsspannung mit dem Source-Anschluß des p-Kanal-Längsregeltransistors verbunden ist. P-Kanal-Längskanaltransistoren werden derzeit in Spannungsreglern für integrierte Schaltungen für den Einsatz in Chipkarten eingesetzt.

Weiterhin sind Spannungsregler mit n-Kanal-Längsregeltransistoren bekannt. Diese weisen eine geringe Spannungsempfindlichkeit auf, da die externe Versorgungsspannung mit dem Drain-Anschluß des n-Kanal-Längsregeltransistors verbunden ist. Nachteilig bei diesem Typ ist jedoch die erhöhte Stromaufnahme, die durch einen zusätzlichen Oszillator und eine zusätzliche Spannungspumpe für die Ansteuerung des Gates des n-Kanal-Transistors notwendig sind. Hierdurch bedingt benötigen Spannungsregler mit einem n-Kanal-Längsregeltransistor eine erhöhte Stromaufnahme, vor allem in einem Ruhezustand. Dadurch bedingt resultiert eine Verletzung der oben genannten GSM bzw. ISO-Normen.

Beispiele von diesen bekannten Spannungsreglern sind den Druckschriften US 6 351 179, US 6 275 096, US 5 072 134 und US 5 929 694 zu entnehmen.

Die Aufgabe der vorliegenden Erfindung besteht darin, eine Spannungsregleranordnung anzugeben, die gegenüber Spannungsspitzen der externen Versorgungsspannung weniger anfällig ist.

Diese Aufgabe wird mit einer Spannungsregleranordnung mit den Merkmalen des Anspruches 1 gelöst. Vorteilhafte Ausgestaltungen der Spannungsregleranordnung ergeben sich aus den abhängigen Ansprüchen.

Die erfindungsgemäße Spannungsregleranordnung weist einen ersten Spannungsregler auf, dessen Eingangsanschluß mit einem Versorgungspotentialanschluß verbunden ist und dessen Ausgangsanschluß mit einem ersten Versorgungspotentialanschluß einer Schaltungsanordnung verbindbar ist. Dabei versorgt der erste Spannungsregler die Schaltungsanordnung in ihrem Ruhezustand mit einer Versorgungsspannung. Weiterhin ist ein zweiter Spannungsregler vorgesehen, dessen Eingangsanschluß mit dem Versorgungspotentialanschluß verbunden ist. Der Ausgangsanschluß des zweiten Spannungsreglers ist mit einem zweiten Versorgungspotentialanschluß der Schaltungsanordnung verbindbar, wobei der zweite Spannungsregler die Schaltungsanordnung in ihrem normalem Betrieb mit einer Versorgungsspannung versorgt.

Bei der erfindungsgemäßen Spannungsregleranordnung sind zwei Spannungsregler vorgesehen. Dabei versorgt der eine Spannungsregler die Schaltungsanordnung in einem Ruhezustand, während der andere Spannungsregler die Schaltungsanordnung in ihrem normalem Betrieb mit der Versorgungsspannung beaufschlagt.

Hierdurch ist es möglich, optimierte Spannungsregler für den jeweiligen Zustand der Schaltungsanordnung (Ruhezustand oder Normalbetrieb) einzusetzen, so daß einerseits eine drastische Reduzierung der Empfindlichkeit gegenüber Spannungsspitzen der externen Versorgungsspannung und andererseits eine niedrige Stromaufnahme in dem Ruhezustand möglich ist. Insbesondere bei der Verwendung der Spannungsregleranordnung in batteriebetriebenen Applikationen ergibt sich hierdurch eine gegenüber konventionellen Anordnungen sehr stark erhöhte Standby-Zeit.

In einer bevorzugten Ausgestaltung weist der erste Spannungsregler einen Längsregeltransistor des ersten Leitfähigkeitstyps auf. Der zweite Spannungsregler weist hingegen vorzugsweise einen Längsregeltransistor des zweiten Leitfähigkeitstyps auf. Hierdurch bedingt kann ein Spannungsregler auf eine geringe Stromaufnahme hin optimiert werden, während der andere eine geringe Spannungsempfindlichkeit gegenüber Spannungsspitzen der externen Versorgungsspannung aufweist.

Zweckmäßigerweise weist der erste Spannungsregler einen p-Kanal-Längsregeltransistor auf, der eine nur geringe Stromaufnahme verursacht und somit im Ruhezustand vorteilhaft verwendet wird.

Erfindungsgemäß verfügt der zweite Spannungsregler über Mittel zum Erzeugen einer Hochspannung. Der zweite Spannungsregler, der bevorzugt einen n-Kanal-Längsregeltransistor aufweist, wodurch eine geringe Spannungsempfindlichkeit im Normalbetrieb sichergestellt ist, kann dann mit seinem Drain-Anschluß mit der externen Versorgungsspannung verbunden werden. Um diesen n-Kanal-Längsregeltransistor leitend schalten zu können, ist jedoch an seinem Gate-Anschluß eine gegenüber der Source-Spannung erhöhte Spannung notwendig. Diese wird durch das Mittel zum Erzeugen einer Hochspannung bereitgestellt.

Das Mittel zum Erzeugen der Hochspannung umfaßt eine Ladungspumpe und eine Vorrichtung zum Erzeugen eines oszillierenden Signals. Derartige Anordnungen sind unter dem Begriff "Ladungspumpe" bekannt. Diese bestehen aus einer kaskadenförmig aufgebauten Anordnung aus Kondensatoren und Dioden. Durch das oszillierende Signal werden die Kondensatoren der Ladungspumpe mit jedem Takt weiter aufgeladen, so daß dem Gate-Anschluß des n-Kanal-Längsregeltransistors die notwendige Hochspannung zur Verfügung gestellt werden kann.

Erfindungsgemäß weist die Vorrichtung zum Erzeugen eines oszillierenden Signals einen zwischen dem Ausgangsanschluß des zweiten Spannungsreglers und der Ladungspumpe verschalteten Oszillator auf, der mit der an dem Ausgangsanschluß anliegenden Spannung betrieben wird und während des normalen Betriebes der Schaltungsanordnung die Ladungspumpe mit einem Signal beaufschlagt.

Weiterhin ist vorgesehen, daß die Vorrichtung zum Erzeugen eines oszillierenden Signals einen zwischen dem Ausgangsanschluß des ersten Spannungsreglers und der Ladungspumpe verschalteten Level-Shifter aufweist, der von einem externen Taktsignal betrieben wird und die Ladungspumpe mit einem Signal beaufschlagt, so lange der Oszillator noch nicht durch den zweiten Spannungsregler gespeist werden kann. Der Level-Shifter dient dazu, die Amplitude des Taktsignales auf einen vorgegebenen Wert zu bringen.

Die Ladungspumpe, die zum Erzeugen der Hochspannung ein oszillierendes Steuersignal benötigt, wird also von zwei unterschiedlichen Vorrichtungen mit dem oszillierenden Steuersignal beaufschlagt. So lange der zweite Spannungsregler noch keine stabile Ausgangsspannung erzeugt, wird das oszillierende Signal durch den levelgeshifteten externen Takt bereitgestellt. Sobald der zweite Spannungsregler seine vorgesehene Ausgangsspannung stabil erreicht hat, wird ein anderer Oszillator mit dieser Ausgangsspannung betrieben, dessen oszillierendes Signal sodann der Ladungspumpe zugeführt wird. Der levelgeshiftete externe Takt wird ab diesem Zeitpunkt nicht mehr benötigt. Um diese Umschaltung zu ermöglichen, ist deshalb ein Schaltelement vorgesehen, dessen Ausgang an der Ladungspumpe und dessen Eingänge mit dem levelgeshifteten externen Takt bzw. dem von der Ausgangsspannung des zweiten Spannungsreglers betriebenen Oszillator verbunden sind. Die Umschaltung durch das Schaltelement erfolgt abhängig von der an dem Ausgangsanschluß des zweiten Spannungsreglers anliegenden Spannung.

Erfindungsgemäß ist zumindest ein weiterer zweiter Spannungsregler vorgesehen, der zur Versorgung weiterer Schaltungsanordnungen dient. Bei diesen Schaltungsanordnungen kann es sich um beliebige, von der eingangs genannten Schaltungsanordnung unterschiedliche Funktionselemente handeln.

Vorzugsweise werden die zweiten Spannungsregler von einer Spannungsreferenzschaltung mit einer Referenzspannung beaufschlagt. Die Spannungsreferenzschaltung verfügt vorzugsweise über einen Spannungsregler mit einem Längsregeltransistor vom zweiten Leitfähigkeitstyp und wird im normalen Betrieb von dem Mittel zum Erzeugen einer Hochspannung gespeist. Als Spannungsreferenzschaltung kann eine Bandabstandsreferenz, eine sogenannte Bandgapschaltung verwendet werden.

Bevorzugt sind im Ruhezustand der Schaltungsanordnung bzw. weiteren Schaltungsanordnungen alle Spannungsregler mit Längsregeltransistoren vom zweiten Leitfähigkeitstyp abgeschaltet. Im Ruhezustand ist folglich nur noch der erste Spannungsregler aktiv, der die Schaltungsanordnung und ggf. auch die weiteren Schaltungsanordnungen mit einer Versorgungsspannung beaufschlagt. Da gemäß dem Gedanken der Erfindung der erste Spannungsregler eine geringe Stromaufnahme aufweist, benötigt die integrierte Gesamtschaltung, bestehend aus der Spannungsregleranordnung und der Schaltungsanordnung bzw. Schaltungsanordnungen eine äußerst geringe Stromaufnahme.

Die Erfindung wird anhand der nachfolgenden Figur näher erläutert.

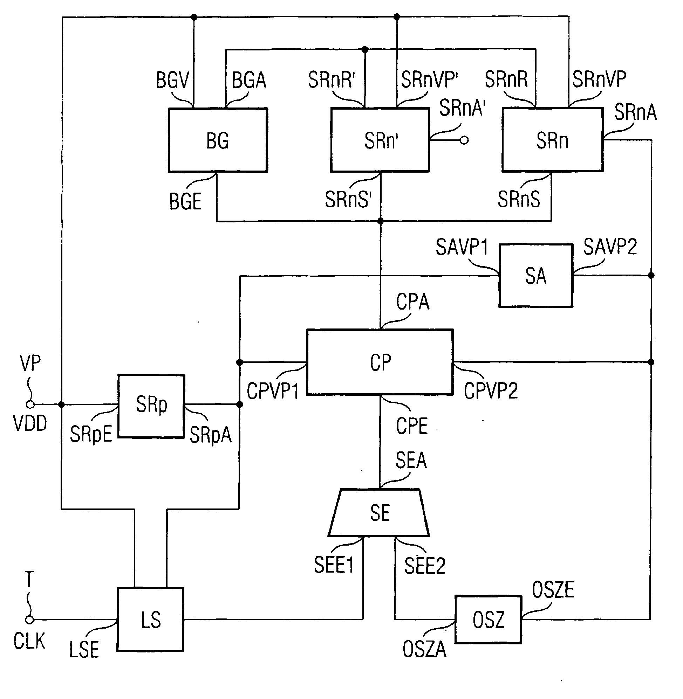

Die Figur stellt eine integrierte Schaltung mit einem erfindungsgemäßen Spannungsregler und einer Schaltungsanordnung dar.

Ein erster Spannungsregler SRp ist mit einem Eingangsanschluß SRpE mit einem Versorgungspotentialanschluß VP verbunden, an dem ein Versorgungspotential VDD anliegt. Ein Ausgangsanschluß SRpA ist mit einem ersten Versorgungspotentialanschluß SAVP1 einer Schaltungsanordnung SA verbunden. Der erste Spannungsregler SRp verfügt über einen p-Kanal-Längsregeltransistor und versorgt die Schaltungsanordnung SA in ihrem Ruhezustand mit einer Versorgungsspannung.

Die Schaltungsanordnung SA verfügt darüber hinaus über einen zweiten Versorgungspotentialanschluß SAVP2, der mit einem Ausgangsanschluß SRnA eines zweiten Spannungsreglers SRn verbunden ist. Eingangsseitig ist der zweite Spannungsregler SRn an seinem Eingangsanschluß SRnVP ebenfalls mit dem Versorgungspotential VDD beaufschlagt. Der zweite Spannungsregler SRn verfügt über einen n-Kanal-Längsregeltransistor. Bei diesen Spannungsreglern ist regelmäßig der Drain-Anschluß des n-Kanal-Regeltransistors mit der externen Versorgungsspannung VDD verbunden. Hierdurch bedingt benötigt der Spannungsregler SRn ein Mittel zum Erzeugen einer Hochspannung, welches den Gate-Anschluß des Längsregeltransistors auf ein höheres Potential bezüglich des zu erzeugenden internen Versorgungspotentials SRnA bringt.

Zu diesem Zweck ist ein Steuersignalanschluß SRnS des zweiten Spannungsreglers SRn mit dem Ausgangsanschluß CPA einer Ladungspumpe CP verbunden. Bei dieser Ladungspumpe CP handelt es sich um eine kaskadenförmig aufgebaute Anordnung aus Kondensatoren und Dioden. Ihre Versorgungsspannung erhält die Ladungspumpe CP über einen ersten Versorgungspotentialanschluß CPVP1, der mit dem Ausgang des ersten Spannungsreglers SRp verbunden ist, oder alternativ über einen zweiten Versorgungspotentialanschluß CPVP2, der mit dem Ausgang SRnA des zweiten Spannungsreglers SRn verbunden ist. Die genaue Funktionsweise, zu welchem Zeitpunkt die Ladungspumpe CP über welchen Versorgungspotentialanschluß CPVP1 oder CPVP2 versorgt wird, ergibt sich aus der weiter unten folgenden Beschreibung der Funktionsweise der Spannungsregleranordnung.

Zur Erzeugung einer Hochspannung benötigt die Ladungspumpe CP darüber hinaus ein oszillierendes Signal. Dieses wird ihr über einen Eingangsanschluß CPE entweder von einem Oszillator OSZ oder als levelgeshifteter externer Takt zugeführt.

Der Oszillator OSZ ist eingangsseitig mit dem Ausgangsanschluß SRnA des zweiten Spannungsreglers SRn verbunden. Der Ausgangsanschluß OSZA des Oszillators OSZ ist mit einem zweiten Eingangsanschluß SEE2 eines Schaltelementes SE verbunden, welches ausgangsseitig eine Verbindung zu dem Eingangsanschluß CPE der Ladungspumpe CP aufweist. Der Oszillator OSZ wird somit mit der an dem Ausgangsanschluß SRnA anliegenden Spannung des zweiten Spannungsreglers betrieben.

Dem gegenüber wird der Level-Shifter LS über einen Eingangsanschluß LSE von einem an einem Taktsignalanschluß T der integrierten Schaltung anliegenden Taktsignal CLK betrieben. Der Level-Shifter LS ist weiterhin mit dem Ausgang SRpA und dem Eingang SRpE des ersten Spannungsreglers SRp verbunden. Ausgangsseitig ist der Level-Shifter mit einem ersten Eingangsanschluß SEE1 des Schaltelementes SE verbunden. Alternativ könnte anstelle des levelgeshifteten externen Taktes ein Oszillator, der von der Ausgangsspannung SRpA des ersten Spannungsreglers SRp versorgt wird, diesen Takt generieren und ausgangsseitig mit dem ersten Eingangsanschluß SEE1 verbunden werden.

Bei dem Schaltelement SE handelt es sich um einen Multiplexer, der abhängig von der an dem Ausgangsanschluß SRnA des zweiten Spannungsreglers SRn anliegenden Spannung gesteuert wird.

Der zweite Spannungsregler SRn verfügt weiterhin über einen Referenzspannungsanschluß SRnR, der mit einem Ausgangsanschluß BGA einer Spannungsreferenzschaltung BG verbunden ist. Bei der Spannungsreferenzschaltung kann es sich beispielsweise um eine Bandabstandsreferenz oder Bandgap handeln. Ihre Versorgungsspannungen erhält die Spannungsreferenzschaltung BG über einen Versorgungspotentialanschluß BGV, der mit dem Versorgungspotential VDD an dem Versorgungspotentialanschluß VP beaufschlagt ist und über einen Eingangsanschluß BGE, der mit dem Ausgangsanschluß CPA der Ladungspumpe CP verbunden ist.

Nachfolgend wird die Funktionsweise der erfindungsgemäßen Spannungsregleranordnung näher erläutert.

Beim Anlegen der externen Versorgungsspannung VDD wird über den ersten Spannungsregler SRp an seinem Ausgang SRpA eine Spannung generiert, die in etwa der Versorgungsspannung der Schaltungsanordnung SA entspricht. Soll die integrierte Schaltung aus ihrem Ruhezustand in ihren Normalbetrieb übergeführt werden, so wird die an dem Ausgang SRpA anliegende Spannung über den Versorgungspotentialanschluß CPVP1 der Ladungspumpe CP zugeführt.

Vorher wird an den Taktsignalanschluß T ein Taktsignal CLK angelegt, so daß der Level-Shifter LS über das Schaltelement SE der Ladungspumpe CP ein oszillierendes Signal zur Verfügung stellen kann. Die Ladungspumpe CP kann hierdurch an ihrem Ausgangsanschluß CPA eine Hochspannung bereitstellen, die dem zweiten Spannungsregler SRn an ihrem Steuersignalanschluß SRnS bereitgestellt wird. Die an dem Ausgangsanschluß CPA anliegende Hochspannung wird ferner über den Eingangsanschluß BGE der Spannungsreferenzschaltung BG zur Verfügung gestellt. Dadurch ist der zweite Spannungsregler SRn in der Lage, eine Ausgangsspannung aufzubauen, die er über seinen Ausgangsanschluß SRnA zur Verfügung stellt.

Die von dem zweiten Spannungsregler SRn erzeugte Ausgangsspannung wird über den zweiten Versorgungspotentialanschluß SAVP2 der Schaltungsanordnung SA zur Verfügung gestellt. Ab diesem Zeitpunkt wird der erste Spannungsregler SRp, der aufgrund seiner p-Kanal-Transistoren eine hohe Spannungsempfindlichkeit aufweist, nicht mehr benötigt.

Die von dem zweiten Spannungsregler SRn erzeugte Ausgangsspannung wird weiterhin dem Oszillator OSZ zur Verfügung gestellt. Das Schaltelement SE erkennt die nunmehr stabile Ausgangsspannung an dem Ausgangsanschluß SRnA und übernimmt eine Umschaltung auf den Oszillator OSZ, so daß das oszillierende Signal nun nicht mehr über den Level-Shifter LS, sondern über den Oszillator OSZ der Ladungspumpe CP bereitgestellt wird.

Im Ruhezustand werden der Oszillator OSZ, die Ladungspumpe CP und alle einen n-Kanal-Regeltransistor aufweisenden Spannungsregler, also alle zweiten Spannungsregler, und die Spannungsreferenzschaltung, abgeschaltet. Die Spannungsversorgung der Schaltungsanordnung SA erfolgt in diesem Ruhezustand mittels des ersten Spannungsreglers SRp, der somit nur noch einen relativ kleinen Strom aufbringen muß und dessen Eigenstrombedarf andererseits sehr gering ist.

Die erfindungsgemäße Spannungsregleranordnung ermöglicht eine drastische Reduzierung der Anfälligkeit gegenüber Spannungsspitzen im Normalbetrieb, wobei eine äußerst niedrige Stromaufnahme im Ruhezustand sichergestellt ist. Im Normalbetrieb werden die Spannungsschwankungen aufgrund der ausschließlichen Verwendung von Spannungsreglern mit n-Kanal-Längsregeltransistoren drastisch reduziert. Im Ruhezustand wird der Strom lediglich von einem p-Kanal-Längsregeltransistor verbraucht. Oszillatoren, Ladungspumpen und n-Kanal-Längsregeltransistoren sind hingegen abgeschaltet. Durch das Umschalten auf den internen Oszillator OSZ versorgt sich die integrierte Schaltung zudem selbst. Es gibt somit neben den Drain-Anschlüssen der n-Kanal-Längsregeltransistoren keine weitere Verbindung zu externen Anschlüssen. Hieraus ergibt sich eine von Haus aus sehr gute Störspannungsunterdrückung.

Die Spannungsregleranordnung kann darüber hinaus neben dem zweiten Spannungsregler SRn über weitere zweite Spannungsregler SRn verfügen. Ein Steuersignalanschluß SRnS ist dann ebenfalls mit dem Ausganganschluß CPA der Ladungspumpe CP verbunden. Ein Versorgungspotentialanschluß SRnVP ist mit dem Ausgangsanschluß BGA der Spannungsreferenzschaltung BG verbunden. Ein Ausgangsanschluß SRnA ist mit einer weiteren (aus der Figur nicht ersichtlichen) Schaltungsanordnung verbindbar. Diese kann andere funktionelle Aufgaben übernehmen. Die Funktionsweise und Ansteuerung des weiteren zweiten Spannungsreglers erfolgt in der oben beschriebenen Art und Weise.

Bezugszeichenliste
- VP: Versorgungspotentialanschluß
- VDD: Versorgungspotential
- T: Taktsignalanschluß
- CLK: Taktsignal
- SRp: Spannungsregler (p-Kanal; erster Typ)
- SRpE: Eingangsanschluß
- SRpA: Ausgangsanschluß
- LS: Level Shifter
- LSE: Eingangsanschluß
- LSA: Ausgangsanschluß
- SE: Schaltelement
- SEE1: erster Eingangsanschluß
- SEE2: zweiter Eingangsanschluß
- SEA: Ausgangsanschluß
- CP: Ladungspumpe
- CPE: Eingangsanschluß
- CPA: Ausgangsanschluß
- CPVP1: erster Versorgungspotentialanschluß
- CPVP2: zweiter Versorgungspotentialanschluß
- OSZ: Oszillator
- OSZE: Eingangsanschluß
- OSZA: Ausgangsanschluß
- BG: Spannungsreferenzschaltung
- BGV: Versorgungspotentialanschluß
- BGE: Eingangsanschluß
- BGA: Ausgangsanschluß
- SRn, Rn': Spannungsregler (n-Kanal, zweiter Typ)
- SRnR, SRnR': Referenzspannungsanschluß
- SRnVP, SRnVP': Versorgungspotentialanschluß
- SRnA, SRnA': Ausgangsanschluß
- SRnS, SRnS: Steuersignalanschluß
- SA: Schaltungsanordnung
- SAVP1: erster Versorgungspotentialanschluß
- SAVP2: zweiter Versorgungspotentialanschluß

## Patentansprüche

1. Spannungsregleranordnung mit einem Versorgungspotentialanschluß (VP), an den ein Versorgungspotential (VDD) anlegbar ist, bestehend aus
a.) einem ersten Spannungsregler (SRp), dessen Eingangsanschluß (SRpE) mit dem Versorgungspotentialanschluß (VP) verbunden ist und dessen Ausgangsanschluß (SRpA) mit einem ersten Versorgungspotentialanschluß (SAVP1) einer Schaltungsanordnung (SA) verbindbar ist, wobei der erste Spannungsregler (SRp) die Schaltungsanordnung (SA) in einem Ruhezustand mit einer Versorgungsspannung versorgt, und
b.) mindestens einem zweiten Spannungsregler (SRn, CP, SE, LS, OSZ), dessen Eingangsanschluß (SRnE) mit dem Versorgungspotentialanschluß (VP) verbunden ist und dessen Ausgangsanschluß (SRnA) mit einem zweiten Versorgungspotentialanschluß (SAVP2) der Schaltungsanordnung (SA) verbindbar ist, wobei der zweite Spannungsregler (SRn, CP, SE, LS, OSZ) die Schaltungsanordnung (SA) in ihrem normalen Betrieb mit einer Versorgungsspannung versorgt und über Mittel (CP, SE, LS, OSZ) zum Erzeugen einer Hochspannung verfügt, welche eine Ladungspumpe (CP) und eine Vorrichtung zum Erzeugen eines oszillierenden Signales (OSZ, LS) umfassen, wobei die Vorrichtung zum Erzeugen eines oszillierenden Signales einen zwischen dem Ausgangsanschluß (SRnA) des zweiten Spannungsreglers (SRn) und der Ladungspumpe verschalteten Oszillator (OSZ) aufweist, der mit der an dem Ausgangsanschluß (SRnA) anliegenden Spannung betrieben wird und während des normalen Betriebes der Schaltungsanordnung (SA) die Ladungspumpe (CP) mit einem Signal beaufschlagt,
**dadurch gekennzeichnet, dass**
die Vorrichtung zum Erzeugen eines oszillierenden Signales einen zwischen dem Ausgangsanschluß (SRpA) des ersten Spannungsreglers (SRp) und der Ladungspumpe verschalteten Level-Shifter (LS) aufweist, der von einem externen Taktsignal (CLK) betrieben wird und die Ladungspumpe (CP) mit einem Signal beaufschlagt, solange der Oszillator (OSZ) noch nicht durch den zweiten Spannungsregler (SRn) gespeist werden kann.

2. Spannungsregleranordnung nach Anspruch 1,
**dadurch gekennzeichnet, dass**
der erste Spannungsregler (SRp) einen Längsregeltransistor von einem ersten Leitfähigkeitstyp aufweist.

3. Spannungsregleranordnung nach Anspruch 1 oder 2,
**dadurch gekennzeichnet, dass**
der zweite Spannungsregler (SRn, CP, SE, LS, OSZ) einen Längsregeltransistor von einem zweiten Leitfähigkeitstyp aufweist.

4. Spannungsregleranordnung nach einem der vorhergehenden Ansprüche,
**dadurch gekennzeichnet, dass**
die zweiten Spannungsregler (SRn, SRn') von einer Spannungsreferenzschaltung (BG) mit einer Referenzspannung beaufschlagt werden.

5. Spannungsregleranordnung nach Anspruch 4,
**dadurch gekennzeichnet, dass**
die Spannungsreferenzschaltung (BG) über einen Spannungsregler mit einem Längsregeltransistor vom zweiten Leitfähigkeitstyp verfügt und im normalen Betrieb von dem Mittel zum Erzeugen einer Hochspannung (CP) gespeist wird.

6. Spannungsregleranordnung nach einem der vorhergehenden Ansprüche,
**dadurch gekennzeichnet, dass**
im Ruhezustand der Schaltungsanordnung bzw. Schaltungsanordnungen alle Spannungsregler mit einem Längsregeltransistor vom zweiten Leitfähigkeitstyp abgeschaltet sind.

7. Spannungsregleranordnung nach einem der vorhergehenden Ansprüche,
**dadurch gekennzeichnet, dass**
der erste Spannungsregler (SRp) einen p-Kanal-Längsregeltransistor aufweist.

8. Spannungsregleranordnung nach einem der vorhergehenden Ansprüche,
**dadurch gekennzeichnet, dass**
der zweite Spannungsregler (SRn) einen n-Kanal-Längsregeltransistor aufweist.

## Claims

1. Voltage regulator arrangement having a supply potential connection (VP), to which a supply potential (VDD) can be applied, comprising
a.) a first voltage regulator (SRp), whose input connection (SRpE) is connected to the supply potential connection (VP) and whose output connection (SRpA) can be connected to a first supply potential connection (SAVP1) of a circuit arrangement (SA), with the first voltage regulator (SRp) supplying the circuit arrangement (SA) with a supply voltage in a rest state, and
b.) at least one second voltage regulator (SRn, CP, SE, LS, OSZ), whose input connection (SRnE) is connected to the supply potential connection (VP), and whose output connection (SRnA) can be connected to a second supply potential connection (SAVP2) of the circuit arrangement (SA), with the second voltage regulator (SRn, CP, SE, LS, OSZ) supplying the circuit arrangement (SA) with a supply voltage during its normal operation and having means (CP, SE, LS, OSZ) for producing a high voltage which comprise a charge pump (CP) and an apparatus for producing an oscillating signal (OSZ, LS), the apparatus for producing an oscillating signal having an oscillator (OSZ) which is connected between the output connection (SRnA) of the second voltage regulator (SRn) and the charge pump, is operated with the voltage which is produced at the output connection (SRnA) and applies a signal to the charge pump (CP) during normal operation of the circuit arrangement (SA)
**characterized in that**
the apparatus for producing an oscillating signal has a level shifter (LS), which is connected between the output connection (SRpA) of the first voltage regulator (SRp) and the charge pump, is operated by an external clock signal (CLK) and applies a signal to the charge pump (CP) for as long as the oscillator (OSZ) cannot yet be fed by the second voltage regulator (SRn).

2. Voltage regulator arrangement according to Claim 1,
**characterized in that**
the first voltage regulator (SRp) has a series regulating transistor of a first conductance type.

3. Voltage regulator arrangement according to Claim 1 or 2,
**characterized in that**
the second voltage regulator (SRn, CP, SE, LS, OSZ) has a series regulating transistor of a second conductance type.

4. Voltage regulator arrangement according to one of the preceding claims,
**characterized in that**
the second voltage regulators (SRn, SRn') have a reference voltage applied to them from a voltage reference circuit (BG).

5. Voltage regulator arrangement according to Claim 4,
**characterized in that**
the voltage reference circuit (BG) has a voltage regulator with a series regulating transistor of the second conductance type and, during normal operation, is fed from the means for producing a high voltage (CP).

6. Voltage regulator arrangement according to one of the preceding claims,
**characterized in that**,
when the circuit arrangement or circuit arrangements is or are in the rest state, all the voltage regulators are switched off by a series regulating transistor of the second conductance type.

7. Voltage regulator arrangement according to one of the preceding claims,
**characterized in that**
the first voltage regulator (SRp) has a p-channel series regulating transistor.

8. Voltage regulator arrangement according to one of the preceding claims,
**characterized in that**
the second voltage regulator (SRn) has an n-channel series regulating transistor.

## Revendications

1. Dispositif régulateur de tension comportant une borne de potentiel d'alimentation (VP) à laquelle un potentiel d'alimentation (VDD) peut être appliqué, constitué de :
a) un premier régulateur de tension (SRp) dont la borne d'entrée (SRpE) est reliée à la borne de potentiel d'alimentation (VP) et dont la borne de sortie (SRpA) peut être reliée à une première borne de potentiel d'alimentation (SAVP1) d'un circuit (SA), le premier régulateur de tension (SRp) alimentant avec une tension d'alimentation le circuit (SA) dans un état de repos, et
b) au moins un deuxième régulateur de tension (SRn, CP, SE, LS, OSZ) dont la borne d'entrée (SRnE) est reliée à la borne de potentiel d'alimentation (VP) et dont la borne de sortie (SRnA) peut être reliée à une deuxième borne de potentiel d'alimentation (SAVP2) du circuit (SA), le deuxième régulateur de tension (SRn, CP, SE, LS, OSZ) alimentant avec une tension d'alimentation le circuit (SA) en fonctionnement normal et disposant de moyens (CP, SE, LS, OSZ) qui sont destinés à produire une tension élevée et qui comprennent une pompe de charge (CP) et un dispositif pour produire un signal oscillant (OSZ, LS), le dispositif destiné à produire un signal oscillant comportant un oscillateur (OSZ) qui est branché entre la borne de sortie (SRnA) du deuxième régulateur de tension (SRn) et la pompe de charge, qui est commandé par la tension présente à la borne de sortie (SRnA) et qui alimente la pompe de charge (CP) avec un signal pendant le fonctionnement normal du circuit (SA),
**caractérisé par le fait que** le dispositif destiné à produire un signal oscillant comporte un transposeur de niveau (LS) qui est branché entre la borne de sortie (SRpA) du premier régulateur de tension (SRp) et la pompe de charge, qui est commandé par un signal d'horloge externe (CLK) et qui alimente la pompe de charge (CP) avec un signal tant que l'oscillateur (OSZ) ne peut pas encore être alimenté par le deuxième régulateur de tension (SRn).

2. Dispositif régulateur de tension selon la revendication 1,
**caractérisé par le fait que** le premier régulateur de tension (SRp) comporte un transistor régulateur série d'un premier type de conductivité.

3. Dispositif régulateur de tension selon la revendication 1 ou 2,
**caractérisé par le fait que** le deuxième régulateur de tension (SRn, CP, SE, LS, OSZ) comporte un transistor régulateur série d'un deuxième type de conductivité.

4. Dispositif régulateur de tension selon l'une des revendications précédentes,
**caractérisé par le fait que** les deuxièmes régulateurs de tension (SRn, SRn') sont alimentés avec une tension de référence par un circuit de référence de tension (BG).

5. Dispositif régulateur de tension selon la revendication 4,
**caractérisé par le fait que** le circuit de référence de tension (BG) dispose d'un régulateur de tension avec un transistor régulateur série du deuxième type de conductivité et est alimenté en fonctionnement normal par le moyen destiné à produire une tension élevée (CP).

6. Dispositif régulateur de tension selon l'une des revendications précédentes,
**caractérisé par le fait que**, lorsque le ou les circuits sont à l'état de repos, tous les régulateurs de tension comportant un transistor régulateur série du deuxième type de conductivité sont arrêtés.

7. Dispositif régulateur de tension selon l'une des revendications précédentes,
**caractérisé par le fait que** le premier régulateur de tension (SRp) comporte un transistor régulateur série à canal p.

8. Dispositif régulateur de tension selon l'une des revendications précédentes,
**caractérisé par le fait que** le deuxième régulateur de tension (SRn) comporte un transistor régulateur série à canal n.
